# EUROPEAN PATENT SPECIFICATION

(11) **EP 3 369 797 B1**
(45) Date of publication and mention of the grant of the patent: **06.01.2021**
(21) Application number: 17158842.9
(22) Date of filing: 02.03.2017
(51) Int. Cl.: C09K 5/10

(54) **COOLING LIQUID COMPOSITION FOR A LIQUID COOLING SYSTEM FOR COOLING A HEAT GENERATING ELEMENT ARRANGED ON A PRINTED CIRCUIT BOARD**
KÜHLFLÜSSIGKEITSZUSAMMENSETZUNG FÜR EIN FLÜSSIGKEITSKÜHLSYSTEM ZUR KÜHLUNG EINES WÄRMEERZEUGENDEN, AUF EINER LEITERPLATTE ANGEORDNETEN ELEMENTS
COMPOSITION DE LIQUIDE DE REFROIDISSEMENT DESTINÉ À UN SYSTÈME DE REFROIDISSEMENT POUR REFROIDIR UN ÉLÉMENT GÉNÉRATEUR DE CHALEUR DISPOSÉ SUR UNE CARTE DE CIRCUIT IMPRIMÉ

(43) Date of publication of application: 05.09.2018
(73) Proprietor: EKWB d.o.o., 1218 Komenda (SI)
(72) Inventor: OBLAK, Rok, 4223 Poljane nad Skofjo Loko (SI); TIVADAR, Niko, 9250 Gornja Radgona (SI)
(74) Representative: Schaumburg und Partner Patentanwälte mbB

(56) References cited:
- EP-A1- 1 416 563
- EP-A1- 1 564 277
- DE-A1-102014 203 659
- JP-A- 2001 279 235
- US-A1- 2006 039 112
- US-A1- 2008 283 795
- US-A1- 2016 273 852
- US-B1- 6 203 719

## Description

The invention relates to a cooling liquid composition for a liquid cooling system for cooling a heat generating element arranged on a printed circuit board (PCB).

In the prior art, known cooling liquids for liquid cooling of heat generating integrated circuit elements arranged on a printed circuit board normally comprise as their components distilled or deionized water, freezing point lowering additives, corrosion inhibiting additives (i.e. chemical compounds that decrease the corrosion rate of a material), biological growth inhibiting additives and dyes or pigments for colouring of the liquid. In case of producing known cooling liquids with a cloudy or opaque appearance, an opacity pigment is typically added in the form of a pigment powder. Normally, titanium dioxide (TiO2), aluminum oxide (Al2O3) or zinc oxide (ZnO) is used as the opacity pigment. However, the afore-mentioned opacity pigments or pigment powders are only added in an unspecified quantity in the form of a water suspension.

In particular, the afore-mentioned opacity pigments (i.e. TiO2, Al2O3 and ZnO) each are of anorganic origin and are substantially not water soluble. Thus, the opacity pigments known from the prior art can only be added to the cooling liquids in the form of a micropowder or nanopowder suspension. The consequences of using such cooling liquids in a liquid cooling system is that when the system operation is not constant, i.e. when the liquid cooling pump is not operating steadily or has downtimes of shorter and longer periods, a sedimentation of the micropowder or nanopowder pigment particles in the suspension may occur. This is substantially due to the fact that the retention of the pigment particles in the suspension will no longer be adequate.

The above-mentioned sedimentation typically occurs after periods of non-operation of the system or when the liquid cooling pump for recirculating the cooling liquid does not provide the required forced cooling liquid flow which helps maintaining the microparticle and nano-particle retention in the suspension. As a consequence, the tiny pigment particles may sink into the microchannels of the liquid cooling heat exchangers and the thin and narrow liquid tubes of the air-water heat exchangers (radiators) of the system. Such a scenario may result in a blockage of the cooling liquid flow within the system and may eventually prevent the liquid cooling system from operation. For example, pigment particles which sink or are inside the pump volute and on the rotor may prevent the spin-up on start-up or may even damage the liquid cooling pump by overloading the motor due to the pigment particles or powder accumulating inside the pump volute. A nonworking liquid cooling pump, in turn, will result in a catastrophic failure of the liquid cooling system as the system is substantially unable to operate under a heavy thermal load without proper operation of the pump.

Further, the known cooling liquids also have the disadvantage that hard-to-remove dried up stains maybe left on the surface of the liquid cooling heat exchangers. Most commonly, the only method for a successful removal of such stains originating from the dried out pigment particles contained in the liquid is mechanical abrasion (i.e. polishing or sanding). This, however, can cause a damage of the liquid heat exchanger equipment.

Thus, a general problem of known cooling liquids is that the same only provide an inadequate retention of pigment particles contained in the liquid which is associated with a sub-optimal cooling liquid flow within the liquid cooling system.

Document EP 1 416 563 A1 discloses a fuel cell coolant composition comprising de-ionized water, a water-soluble polymeric ion suppressant and an organic corrosion inhibitor. The water-soluble polymeric ion suppressant is Polystyrene.

Document US 6 203 719 B1 discloses an antifreeze/coolant composition comprising a glycol compound, polymeric polycarboxylate and a silicone-silicate copolymer.

Document EP 1564 277 A1 discloses a heat transfer medium comprising water and/or alcohol and one or more polycarboxylic acids and/or salts thereof. In an example a maleic acid-acrylic-acid-vinyl acetate copolymer is used.

Document US 2008/0283795 A1 discloses a composition for a radiator antifreeze for use in an internal combustion engine. The composition being an aqueous solution of the sodium salt of 2-ethylhexanoic acid and a copolymer made of unsaturated carboxylic acids or olefins.

Document P2001-279235 discloses a composition of a coolant for use in an internal combustion engine, the coolant comprising a maleic acid/acrylic acid copolymer.

It is an object of the invention to specify a cooling liquid composition for a liquid cooling system for cooling a heat generating element arranged on a printed circuit board allowing for an optimal flow of the cooling liquid within the liquid cooling system.

This object is solved by a cooling liquid composition having the features of claim 1. Advantageous developments of the invention are specified in the dependent claims.

According to an embodiment, a cooling liquid composition for a liquid cooling system for cooling a heat generating element arranged on a printed circuit board is provided. The cooling liquid composition comprises an aqueous solution comprising a copolymer having a copolymer concentration in a range of 0.05% to 20% by mass. In particular, the copolymer concentration is in the range of 0.06% to 15% by mass, 0.07% to 13% by mass, 0.08% to 12% by mass, or 0.09% to 11% by mass, preferably 0.1% to 10% by mass. Thereby, it is possible to avoid a sub-optimal cooling liquid flow within the liquid cooling system resulting from an inadequate retention of pigment particles contained in the liquid. Thus, an optimal flow of the cooling liquid within the liquid cooling system can be achieved. The optimal cooling liquid flow, in turn, allows to significantly reduce the risk of a failure of the liquid cooling system due to a blockage of the cooling channels or a damage to the liquid cooling pump resulting from a particle or powder accumulation inside the pump volute and impeller.

The copolymer comprises 2-Propenoic acid, 2-methyl-, polymer with ethenylbenzene. The use of this specific copolymer allows to provide a stable cloudy or opaque visual appearance for the cooling liquid.

It is advantageous when the cooling liquid composition comprises copolymer particles having an average diameter in a range of 0.1 µm to 0.5 µm. In particular, the copolymer particles have an average diameter in the range of 0.15 µm to 0.4 µm, preferably 0.18 µm to 0.35 µm. Due to the relatively small size of the copolymer particles, a degradation of the cooling liquid flow can substantially be prevented.

For example, the cooling liquid composition may further comprise a pigment and/or a dye. By providing additional pigments and/or dyes, it is possible to achieve a desired visual colour effect for the cooling liquid. In particular, the provision of a dissolved dye allows to obtain a relatively stable visual colour effect while not adversely affecting the cooling liquid flow.

Preferably, the cooling liquid composition further comprises a pigment which does not comprise titanium dioxide, aluminum oxide, or zinc oxide. Due to the omission of such compounds, possible pigment particle retention issues can effectively be avoided.

It is advantageous when the cooling liquid composition further comprises propylene glycol having a concentration of 5% to 80% by mass, preferably 10% to 75% by mass. By means of the additional propylene glycol, a suitable freezing point lowering additive can be provided. The use of propylene glycol as the freezing point lowering additive is preferred since the same is relatively environmentally friendly and minimizes the acute poisoning hazard.

Alternatively, the cooling liquid composition may further comprise monoethylene glycol or a compound selected from the group consisting of glycerol, ethanol, and methanol. Such compounds may serve as different freezing point lowering additives. The use of any of such compounds as the freezing point lowering additive can be provided as an alternative to the use of propylene glycol.

It is advantageous when the cooling liquid composition further comprises sodium 2-ethylhexanoate having a concentration of 0.5% to 20% by mass, preferably 1.5% to 15% by mass. By means of the additional sodium 2-ethylhexanoate, an efficient corrosion inhibiting additive can be provided.

Preferably, the cooling liquid composition further comprises 5-Chloro-2-methyl-3(2H)-isothiazolone with 2-methyl-3(2H)-isothiazolone having a concentration of 0.005% to 0.15% by mass, preferably 0.01% to 0.1% by mass. By means of the additional 5-Chloro-2-methyl-3(2H)-isothiazolone with 2-methyl-3(2H)-isothiazolone, an efficient biological growth inhibiting additive can be provided.

Alternatively, the cooling liquid composition may further comprise a mixture of compounds which comprises at least two compounds selected from the group consisting of 1,2-Benzisothiazol-3(2H)-one, N-(3-Aminopropyl)-N-dodecylpropane-1,3-diamine, 5-Chloro-2-methyl-3(2H)-isothiazolone, and 2-Methyl-3(2H)-isothiazolone. Such a mixture of compounds may serve as a different biological growth inhibiting additive. The use of this mixture of compounds as the biological growth inhibiting additive can be provided as an alternative to the use of 5-Chloro-2-methyl-3(2H)-isothiazolone with 2-methyl-3(2H)-isothiazolone.

It is advantageous when the cooling liquid composition further comprises distilled water having a concentration of 10% to 90% by mass, preferably 20% to 80% by mass. The distilled water may serve as a base material. As an alternative to the use of distilled water as the base material, deionized water can also be used.

Preferably, the cooling liquid composition is opaque or translucent.

It is advantageous when the cooling liquid composition further comprises Polyacrylic acid, sodium salt having a concentration of 0.2% to 2% by mass, preferably 0.25% to 1% by mass. By means of the Polyacrylic acid, sodium salt, the long-term stability of the opacifier (i.e. the copolymer) can substantially be increased.

According to an embodiment, a liquid cooling system for cooling a heat generating element arranged on a printed circuit board is provided. The liquid cooling system is configured for generating a flow of a cooling liquid within the liquid cooling system. The cooling liquid comprises a cooling liquid composition comprising an aqueous solution comprising a copolymer. The aqueous solution has a copolymer concentration in a range of 0.05% to 20% by mass.

For example, the heat generating element may be a microprocessor, integrated circuit, or any other PCB component arranged on the printed circuit board, e.g. a memory IC (RAM), a non-volatile storage IC (flash storage), a bus line switch (PCIe switch), an FPGA, an ASIC, an I/O-controller, a PHY controller, a coil, a diode, or a voltage converter.

Further features and advantages of the invention result from the following description which explains the invention in more detail on the basis of embodiments in connection with the enclosed figures:
- Figure 1: shows a table of components or compounds to be used for producing different exemplary cooling liquid compositions; and
- Figure 2a: shows a schematic diagram of an embodiment of a liquid cooling system for cooling a heat generating element arranged on a printed circuit board; and
- Figure 2b: shows a schematic diagram of components of the embodiment of the liquid cooling system according to Figure 2a.

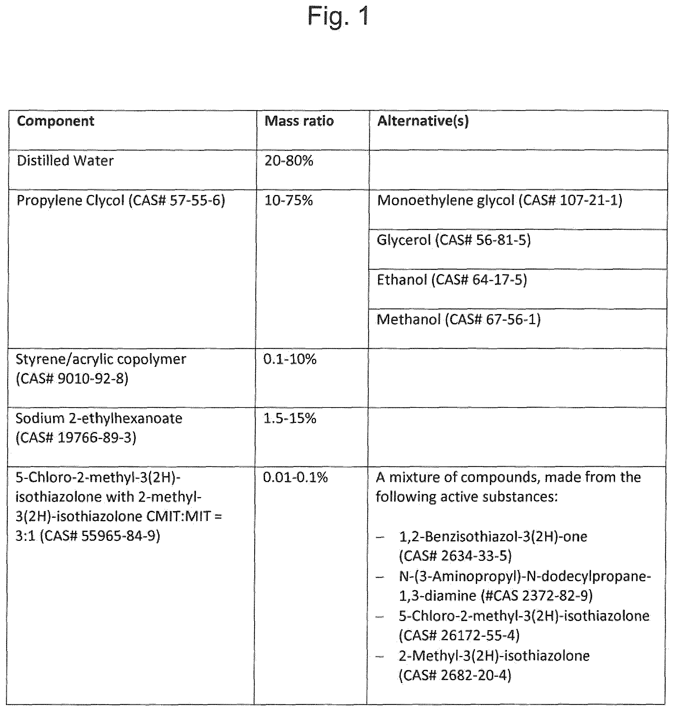

Figure 1 shows a table of components or compounds to be used for producing different exemplary cooling liquid compositions. The first column of the table shown in Figure 1 indicates the different components or compounds to be used for producing a cooling liquid composition according to a preferred embodiment. In this preferred embodiment, the components or compounds to be used specifically are distilled water, propylene glycol (CAS# 57-55-6), styrene/acrylic copolymer (CAS# 9010-92-8), sodium 2-ethylhexanoate (CAS# 19766-89-3), and 5-Chloro-2-methyl-3(2H)-isothiazolone with 2-methyl-3(2H)-isothiazolone (CAS# 55965-84-9) with CMIT:MIT = 3:1. The corresponding concentrations in percentages by mass of these components or compounds are indicated in the second column of the table shown in Figure 1. The third column of the table shown in Figure 1 indicates different components or compounds that can be used as alternatives for producing cooling liquid compositions according to other different embodiments. The components or compounds to be used for producing the other different embodiments specifically are monoethylene glycol (CAS# 107-21-1), glycerol (CAS# 56-81-5), ethanol (CAS# 64-17-5), methanol (CAS# 67-56-1), and a mixture of compounds comprising different active substances, i.e. 1,2-Benzisothiazol-3(2H)-one (CAS# 2634-33-5), N-(3-Aminopropyl)-N-dodecylpropane-1,3-diamine (#CAS 2372-82-9), 5-Chloro-2-methyl-3(2H)-isothiazolone (CAS# 26172-55-4), and 2-Methyl-3(2H)-isothiazolone (CAS# 2682-20-4).

Referring to the table shown in Figure 1, the styrene/acrylic copolymer (CAS# 9010-92-8) is also referred to as 2-Propenoic acid, 2-methyl-, polymer with ethenylbenzene. Further referring to the table shown in Figure 1, CMIT:MIT indicates the ratio of CMIT (Methylchloroisothiazolinone) and MIT (Methylisothiazolinone).

In the preferred embodiment, the cooling liquid composition is produced by adding the aqueous solution of the styrene/acrylic copolymer (CAS# 9010-92-8) in a concentration of 0.1% to 10% by mass to the mixture of the propylene glycol (CAS# 57-55-6) in a concentration of 10% to 75% by mass, distilled (or deionized) water in a concentration of 20% to 80% by mass, the corrosion inhibiting additive sodium 2-ethylhexanoate (CAS# 19766-89-3) in a concentration of 1.5% to 15% by mass, and the biological growth inhibiting additive 5-Chloro-2-methyl-3(2H)-isothiazolone with 2-methyl-3(2H)-isothiazolone (CAS# 55965-84-9) with the ratio CMIT:MIT of 3:1 in a concentration of 0.01% to 0.1%. The cooling liquid composition according to the preferred embodiment is characterized by a cloudy and/or opaque visual appearance. The size of the styrene/acrylic copolymer particles in the aqueous solution is relatively small, i.e. characterized by an average diameter ranging from 0.18 µm to 0.35 µm. The styrene/acrylic copolymer provided in the cooling liquid composition according to the preferred embodiment results in a stable cloudy or opaque visual effect for the cooling liquid.

In this context, it should be noted that concentration values or ranges of the different components or compounds of the cooling liquid composition are always indicated with reference to the mass of the total mixture (and not with reference to the aqueous solution, for example).

In a further preferred embodiment, Polyacrylic acid, sodium salt (CAS# 9003-04-7) can be added to the cooling liquid composition according to the preferred embodiment. Thereby, it is possible to further stabilize the opacifier (i.e. the styrene/acrylic copolymer) in a more demanding environment. In other words, the additional Polyacrylic acid, sodium salt allows to obtain an even more stable cloudy or opaque visual effect for the cooling liquid.

As an alternative to the use of the biological growth inhibiting additive 5-Chloro-2-methyl-3(2H)-isothiazolone with 2-methyl-3(2H)-isothiazolone, a different biological growth inhibiting additive made from the following active substances may be used: 1,2-Benzisothiazol-3(2H)-one (CAS# 2634-33-5), N-(3-Aminopropyl)-N-dodecylpropane-1,3-diamine (#CAS 2372-82-9), 5-Chloro-2-methyl-3(2H)-isothiazolone (CAS# 26172-55-4), and 2-Methyl-3(2H)-isothiazolone (CAS# 2682-20-4).

In the other different embodiments, the cooling liquid composition may also be produced by using monoethylene glycol (CAS# 107-21-1) instead of propylene glycol (CAS# 57-55-6). However, the use of propylene glycol is preferred since thereby, the cooling liquid can be made more environmentally friendly while minimizing the acute poisoning hazard. In addition, producing the cooling liquid composition is not limited to the use of propylene glycol and monoethylene glycol, but can also utilize any of the following anti-freeze additives: methanol, ethanol, and glycerol.

In embodiments, the cooling liquid can also be coloured by using additional dyes or pigments. Typically, the difference between pigment colouring and dye colouring is that in dye colouring, the dye is fully dissolved in the cooling liquid, while pigment colouring results in a suspension. By the combination of a dissolved dye and the specific aqueous solution comprising the copolymer, it is possible to produce a cooling liquid which is characterized by a stable visual colour effect.

Contrary to the prior art, the inventive cooling liquid composition prevents that the cooling liquid may suffer from pigment or powder particle retention issues since it is substantially free of titanium dioxide (TiO2), aluminum oxide (Al2O3), or zinc oxide (ZnO) particles, or a suspension thereof.

Embodiments of the invention provide the advantage that the cooling liquid composition does not induce liquid cooling system failures due to a blockage of the cooling channels or a damage to the liquid cooling pump due to a particle built up inside the volute and impeller of the pump.

Embodiments of the invention also provide a full spectrum corrosion protection for many types of metal, such as aluminum, copper, brass, stainless steel, and are compatible with many types of plastic materials, such as POM, PC, PCCM, PMMA, PPS, ABS, and MABS, which are found inside the liquid cooling system.

The inventive cooling liquid composition is further characterized by allowing for an easy removal of the dried out stains or spots with water or alcohol.

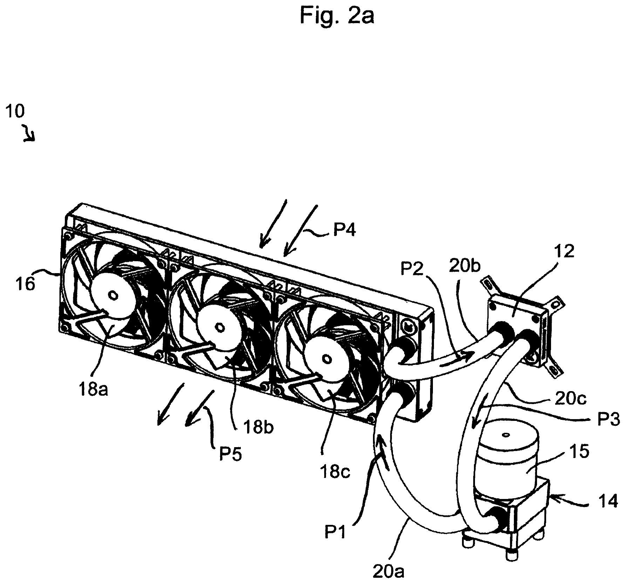

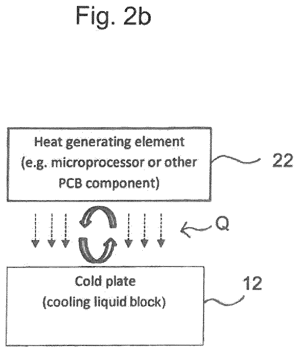

Figure 2a shows a schematic diagram of an embodiment of a liquid cooling system 10 for cooling a heat generating element arranged on a printed circuit board. Figure 2b shows a schematic diagram of components (i.e. cold plate 12 and heat generating element 22) of the embodiment of the liquid cooling system 10 according to Figure 2a. As shown in Figure 2a, the liquid cooling system 10 comprises the cold plate 12, a liquid cooling pump 14 having a liquid reservoir 15 (e.g. an expansion vessel), and a radiator 16. The cold plate 12 may also be referred to as a cooling liquid block. The liquid cooling pump 14 is, for example, a motor-driven pump. The radiator 16 is, for example, a liquid-air heat exchanger and comprises a plurality of fans 18a to 18c. The cold plate 12 and the radiator 16 are connected to the liquid cooling pump 14 by means of flexible cooling tubes 20a to 20c. The embodiment of the liquid cooling system 10 shown in Figure 2a may be integrated into a casing of a computer (e.g. tower PC) for cooling the CPU thereof.

In operation, the cold plate 12 may be in thermal contact with the heat generating element 22 arranged on the printed circuit board. The cold plate 12 is configured to absorb the heat generated by the heat generating element 22. This heat absorption process is represented by the arrows Q in Figure 2b.

Referring to Figure 2a, the liquid cooling system 10 generates a flow of a cooling liquid (e.g. the cooling liquid composition according to the previous embodiments) within the liquid cooling system 10. The flow of the cooling liquid is generated by means of the liquid cooling pump 14. The liquid cooling pump 14 pumps the cooling liquid provided by the liquid reservoir 15 such that the flow of the cooling liquid is generated from the liquid cooling pump 14 to the radiator 16 via the flexible cooling tube 20a, from the radiator 16 to the cold plate 12 via the flexible cooling tube 20b, and from the cold plate 12 to the liquid cooling pump 14 via the flexible cooling tube 20c. This flow of the cooling liquid is represented by the arrows P1 to P3 in Figure 2a.

The cooling process is characterized as follows. The heat generated by the heat generating element 22 is absorbed by the cold plate 12. The cooling liquid flowing through the cold plate 12 absorbs the heat and transfers the same via the liquid cooling pump 14 to the radiator 16. Within the radiator 16, heat dissipation occurs such that the cooling liquid flowing through the same effectively cools down. For the heat dissipation, the radiator 16 may be in thermal contact with relatively cold air on one side (indicated by the arrows P4), and relatively hot air may be generated on the other side of the radiator 16 (indicated by the arrows P5). The relatively hot air may be blown away by means of the fans 18a to 18c of the radiator 16. Consequently, the heat generating element 22 can effectively be cooled by means of the cooling liquid flowing through the cold plate 12 after the heat dissipation within the radiator 16.

## Claims

1. A cooling liquid composition for a liquid cooling system (10) for cooling a heat generating element (22) arranged on a printed circuit board (PCB), wherein the cooling liquid composition comprises:
an aqueous solution comprising a copolymer having a copolymer concentration in a range of 0.05% to 20% by mass, wherein the copolymer comprises 2-Propenoic acid, 2-methyl-, polymer with ethenylbenzene.

2. The cooling liquid composition according to claim 1, wherein the copolymer concentration is in the range of 0.06% to 15% by mass, 0.07% to 13% by mass, 0.08% to 12% by mass, or 0.09% to 11% by mass, preferably 0.1% to 10% by mass.

3. The cooling liquid composition according to one of the claims 1 to 2, wherein the cooling liquid composition comprises copolymer particles having an average diameter in a range of 0.1 µm to 0.5 µm.

4. The cooling liquid composition according to claim 3, wherein the copolymer particles have an average diameter in the range of 0.15 µm to 0.4 µm, preferably 0.18 µm to 0.35 µm.

5. The cooling liquid composition according to one of the claims 1 to 4, wherein the cooling liquid composition further comprises a pigment and/or a dye.

6. The cooling liquid composition according to one of the claims 1 to 5, wherein the cooling liquid composition further comprises a pigment which does not comprise titanium dioxide, aluminum oxide, or zinc oxide.

7. The cooling liquid composition according to one of the claims 1 to 6, wherein the cooling liquid composition further comprises propylene glycol having a concentration of 5% to 80% by mass, preferably 10% to 75% by mass.

8. The cooling liquid composition according to one of the claims 1 to 6, wherein the cooling liquid composition further comprises monoethylene glycol, or wherein the cooling liquid composition further comprises a compound selected from the group consisting of glycerol, ethanol, and methanol.

9. The cooling liquid composition according to one of the claims 1 to 8, wherein the cooling liquid composition further comprises sodium 2-ethylhexanoate having a concentration of 0.5% to 20% by mass, preferably 1.5% to 15% by mass.

10. The cooling liquid composition according to one of the claims 1 to 9, wherein the cooling liquid composition further comprises 5-Chloro-2-methyl-3(2H)-isothiazolone with 2-methyl-3(2H)-isothiazolone having a concentration of 0.005% to 0.15% by mass, preferably 0.01% to 0.1% by mass.

11. The cooling liquid composition according to one of the claims 1 to 9, wherein the cooling liquid composition further comprises a mixture of compounds, wherein the mixture of compounds comprises at least two compounds selected from the group consisting of 1,2-Benzisothiazol-3(2H)-one, N-(3-Aminopropyl)-N-dodecylpropane-1,3-diamine, 5-Chloro-2-methyl-3(2H)-isothiazolone, and 2-Methyl-3(2H)-isothiazolone.

12. The cooling liquid composition according to one of the claims 1 to 11, wherein the cooling liquid composition further comprises distilled water having a concentration of 10% to 90% by mass, preferably 20% to 80% by mass.

13. The cooling liquid composition according to one of the claims 1 to 12, wherein the cooling liquid composition is opaque or translucent.

14. The cooling liquid composition according to one of the claims 1 to 13, wherein the cooling liquid composition further comprises Polyacrylic acid, sodium salt having a concentration of 0.2% to 2% by mass, preferably 0.25% to 1% by mass.

15. A liquid cooling system (10) for cooling a heat generating element (22) arranged on a printed circuit board, wherein the liquid cooling system (10) is configured for generating a flow of a cooling liquid within the liquid cooling system (10), the cooling liquid comprising the cooling liquid composition according to one of the claims 1 to 14.

## Patentansprüche

1. Kühlflüssigkeitszusammensetzung für ein Flüssigkeitskühlsystem (10) zur Kühlung eines wärmeerzeugenden, auf einer Leiterplatte (PCB) angeordneten Elements (22), wobei die Kühlflüssigkeitszusammensetzung umfasst:
eine wässrige Lösung, die ein Copolymer mit einer Copolymerkonzentration in einem Bereich von 0,05 Massen-% bis 20 Massen-% umfasst, wobei das Copolymer 2-Propensäure, 2-Methyl-, Polymer mit Ethenylbenzol umfasst.

2. Kühlflüssigkeitszusammensetzung nach Anspruch 1, wobei die Copolymerkonzentration im Bereich von 0,06 Massen-% bis 15 Massen-%, 0,07 Massen-% bis 13 Massen-%, 0,08 Massenprozent bis 12 Massen-%, oder 0,09 Massen-% bis 11 Massen-%, vorzugsweise 0,1 Massen-% bis 10 Massen-% ist.

3. Kühlflüssigkeitszusammensetzung nach einem der Ansprüche 1 bis 2, wobei die Kühlflüssigkeitszusammensetzung Copolymerpartikel mit einem durchschnittlichen Durchmesser in einem Bereich von 0,1 µm bis 0,5 µm umfasst.

4. Kühlflüssigkeitszusammensetzung nach Anspruch 3, wobei die Copolymerpartikel einen durchschnittlichen Durchmesser im Bereich von 0,15 µm bis 0,4 µm, vorzugweise 0,18 µm bis 0,35 µm haben.

5. Kühlflüssigkeitszusammensetzung nach einem der Ansprüche 1 bis 4, wobei die Kühlflüssigkeitszusammensetzung ferner ein Pigment und/oder einen Farbstoff umfasst.

6. Kühlflüssigkeitszusammensetzung nach einem der Ansprüche 1 bis 5, wobei die Kühlflüssigkeitszusammensetzung ferner ein Pigment umfasst, das kein Titandioxid, Aluminiumdioxid oder Zinkoxid umfasst.

7. Kühlflüssigkeitszusammensetzung nach einem der Ansprüche 1 bis 6, wobei die Kühlflüssigkeitszusammensetzung ferner Propylenglycol mit einer Konzentration von 5 Massen-% bis 80 Massen-%, vorzugsweise 10 Massen-% bis 75 Massen-% umfasst.

8. Kühlflüssigkeitszusammensetzung nach einem der Ansprüche 1 bis 6, wobei die Kühlflüssigkeitszusammensetzung ferner Monoethylenglycol umfasst, oder wobei die Kühlflüssigkeitszusammensetzung ferner eine Verbindung umfasst, die aus der Gruppe bestehend aus Glycerol, Ethanol und Methanol ausgewählt ist.

9. Kühlflüssigkeitszusammensetzung nach einem der Ansprüche 1 bis 8, wobei die Kühlflüssigkeitszusammensetzung ferner Natrium 2-Ethylhexanoat mit einer Konzentration von 0,5 Massen-% bis 20 Massen-%, vorzugsweise 1,5 Massen-% bis 15 Massen-% umfasst.

10. Kühlflüssigkeitszusammensetzung nach einem der Ansprüche 1 bis 9, wobei die Kühlflüssigkeitszusammensetzung ferner 5-Chlor-2-methyl-3(2H)-isothiazolon mit 2-Methyl-3(2H)-Isothiazolon mit einer Konzentration von 0,005 Massen-% bis 0,15 Massen-%, vorzugsweise 0,01 Massen-% bis 0,1 Massen-% umfasst.

11. Kühlflüssigkeitszusammensetzung nach einem der Ansprüche 1 bis 9, wobei die Kühlflüssigkeitszusammensetzung ferner eine Mischung aus Verbindungen umfasst, wobei die Mischung aus Verbindungen mindestens zwei Verbindungen umfasst, die aus der Gruppe bestehend aus 1,2-Benzisothiazol-3(2H)-on, N-(3-Aminopropyl)-N-dodecylpropan-1,3-diamin, 5-Chlor-2-methyl-3(2H)-isothiazolon und 2-Methyl-3(2H)-isothiazolon ausgewählt sind.

12. Kühlflüssigkeitszusammensetzung nach einem der Ansprüche 1 bis 11, wobei die Kühlflüssigkeitszusammensetzung ferner destilliertes Wasser mit einer Konzentration von 10 Massen-% bis 90 Massen-%, vorzugsweise 20 Massen-% bis 80 Massen-% umfasst.

13. Kühlflüssigkeitszusammensetzung nach einem der Ansprüche 1 bis 12, wobei die Kühlflüssigkeitszusammensetzung undurchsichtig oder lichtdurchlässig ist.

14. Kühlflüssigkeitszusammensetzung nach einem der Ansprüche 1 bis 13, wobei die Kühlflüssigkeitszusammensetzung ferner Polyacrylsäure, Natriumsalz mit einer Konzentration von 0,2 Massen-% bis 2 Massen-%, vorzugsweise 0,25 Massen-% bis 1 Massen-% umfasst.

15. Flüssigkeitskühlsystem (10) zur Kühlung eines wärmeerzeugenden, auf einer Leiterplatte angeordneten Elements (22), wobei das Flüssigkeitskühlsystem (10) ausgebildet ist, um einen Fluss einer Kühlflüssigkeit innerhalb des Flüssigkeitskühlsystems (10) zu erzeugen, wobei die Kühlflüssigkeit die Kühlflüssigkeitszusammensetzung nach einem der Ansprüche 1 bis 14 umfasst.

## Revendications

1. Composition de liquide de refroidissement pour un système de refroidissement liquide (10) pour refroidir un élément générateur de chaleur (22) agencé sur une carte de circuit imprimé (PCB), dans laquelle la composition de liquide de refroidissement comprend :
une solution aqueuse comprenant un copolymère ayant une concentration en copolymère dans une plage de 0,05 % à 20 % en masse, dans laquelle le copolymère comprend un polymère d'acide 2-propénoïque, 2-méthyl- avec de l'éthénylbenzène.

2. Composition de liquide de refroidissement selon la revendication 1, dans laquelle la concentration en copolymère est dans la plage de 0,06 % à 15 % en masse, de 0, 07 % à 13 % en masse, de 0,08 % à 12 % en masse, ou de 0,09 % à 11 % en masse, de préférence de 0,1 % à 10 % en masse.

3. Composition de liquide de refroidissement selon l'une des revendications 1 à 2, dans laquelle la composition de liquide de refroidissement comprend des particules de copolymère ayant un diamètre moyen dans une plage de 0,1 *µ*m à 0,5 *µ*m.

4. Composition de liquide de refroidissement selon la revendication 3, dans laquelle les particules de copolymère ont un diamètre moyen dans la plage de 0, 15 *µ*m à 0,4 *µ*m, de préférence de 0,18 *µ*m à 0,35 *µ*m.

5. Composition de liquide de refroidissement selon l'une des revendications 1 à 4, dans laquelle la composition de liquide de refroidissement comprend en outre un pigment et/ou un colorant.

6. Composition de liquide de refroidissement selon l'une des revendications 1 à 5, dans laquelle la composition de liquide de refroidissement comprend en outre un pigment qui ne comprend pas de dioxyde de titane, oxyde d'aluminium, ou oxyde de zinc.

7. Composition de liquide de refroidissement selon l'une des revendications 1 à 6, dans laquelle la composition de liquide de refroidissement comprend en outre du propylène glycol ayant une concentration de 5 % à 80 % en masse, de préférence de 10 % à 75 % en masse.

8. Composition de liquide de refroidissement selon l'une des revendications 1 à 6, dans laquelle la composition de liquide de refroidissement comprend en outre du monoéthylène glycol, ou dans laquelle la composition de liquide de refroidissement comprend en outre un composé choisi parmi le groupe constitué de glycérol, éthanol, et méthanol.

9. Composition de liquide de refroidissement selon l'une des revendications 1 à 8, dans laquelle la composition de liquide de refroidissement comprend en outre du 2-éthylhexanoate de sodium ayant une concentration de 0,5 % à 20 % en masse, de préférence de 1,5 % à 15 % en masse.

10. Composition de liquide de refroidissement selon l'une des revendications 1 à 9, dans laquelle la composition de liquide de refroidissement comprend en outre de la 5-chloro-2-méthyl-3(2H)-isothiazolone avec de la 2-méthyl-3(2H)-isothiazolone ayant une concentration de 0,005 % à 0,15 % en masse, de préférence de 0,01 % à 0,1 % en masse.

11. Composition de liquide de refroidissement selon l'une des revendications 1 à 9, dans laquelle la composition de liquide de refroidissement comprend en outre un mélange de composés, dans laquelle le mélange de composés comprend au moins deux composés choisis parmi le groupe constitué de 1,2-benzisothiazol-3(2H)-one, N-(3-aminopropyl)-N-dodécylpropane-1,3-diamine, 5-chloro-2-méthyl-3(2H)-isothiazolone, et 2-méthyl-3(2H)-isothiazolone.

12. Composition de liquide de refroidissement selon l'une des revendications 1 à 11, dans laquelle la composition de liquide de refroidissement comprend en outre de l'eau distillée ayant une concentration de 10 % à 90 % en masse, de préférence 20 % à 80 % en masse.

13. Composition de liquide de refroidissement selon l'une des revendications 1 à 12, dans laquelle la composition de liquide de refroidissement est opaque ou translucide.

14. Composition de liquide de refroidissement selon l'une des revendications 1 à 13, dans laquelle la composition de liquide de refroidissement comprend en outre de sel de sodium d'acide polyacrylique, ayant une concentration de 0,2 % à 2 % en masse, de préférence de 0,25 % à 1 % en masse.

15. Système de refroidissement liquide (10) pour refroidir un élément générateur de chaleur (22) agencé sur une carte de circuit imprimé, dans lequel le système de refroidissement liquide (10) est configuré pour générer un écoulement d'un liquide de refroidissement à l'intérieur du système de refroidissement liquide (10), le liquide de refroidissement comprenant la composition de liquide de refroidissement selon l'une des revendications 1 à 14.
